# EUROPEAN PATENT APPLICATION

(11) **EP 3 943 827 A1**
(43) Date of publication of application: **26.01.2022**
(21) Application number: 20773488.0
(22) Date of filing: 23.01.2020
(51) Int. Cl.: F24F 11/74, F24F 3/044, F24F 7/06, G06F 1/20, H05K 7/20, F24F 110/40

(54) **DATA CENTER AIR CONDITIONING CONTROL DEVICE, METHOD, NON-TRANSITORY COMPUTER READABLE MEDIUM, AND AIR CONDITIONING SYSTEM**

(30) Priority: 18.03.2019 JP 2019049262
(71) Applicant: NEC Corporation, 108-8001 Tokyo (JP)
(72) Inventor: MIYAMOTO Yoshinori, Tokyo 108-8001 (JP); YOSHIKAWA Minoru, Tokyo 108-8001 (JP); RAJPUT Nirmal Singh, Tokyo 108-8001 (JP); NATSUMEDA Takafumi, Tokyo 108-8001 (JP)
(74) Representative: Vossius & Partner Patentanwälte Rechtsanwälte mbB
(86) International application number: PCT/JP2020/002306
(87) International publication number: WO 2020/189001

(57) **Abstract**

An air conditioning control device (13) includes a differential pressure calculation unit (44) that calculates differential pressure between the intake side and the exhaust side of a rack (11) containing at least one server (18), and a rotational speed control unit (45) that controls the rotational speed of an air conditioning fan (30) on the basis of the differential pressure. The rotational speed control unit (45) increases or decreases the rotational speed of the air conditioning fan (30) depending on the variation of the differential pressure in the event of a change in the rotational speed of the air conditioning fan (30).

## Description

### Technical Field

The present invention relates to an air conditioning control device and method for a data center, a non-transitory computer readable medium, and an air conditioning system. Particularly, the present invention relates to an air conditioning control device, method, program, and an air conditioning system capable of properly controlling the rotational speed of an air-conditioning fan for cooling a server of a data center by suitable supply cool air.

### Background Art

In a data center, in order for servers mounted on racks to operate in a favorable environment, it is necessary to place an air conditioner for supplying cool air to servers and properly control the volume of cool air supplied from the air conditioner to the servers (which is hereinafter referred to simply as supply cool air). For example, when the volume of supply cool air is too high, the servers are excessively cooled, and electricity cost increases. When, on the other hand, the volume of supply cool air is too low, the temperature of cool air which the servers draw in (which is hereinafter referred to simply as intake air) increases due to the short-circuit phenomenon where servers draw in exhaust air from the themselves, which deteriorates the operating environment of the servers. Thus, in order to maintain the favorable operating environment of the servers and reduce the power consumption of the air conditioner, it is necessary to adjust the volume of supply cool air in an appropriate manner.

However, since it is difficult to accurately measure the volume of supply cool air, it is not easy to control the volume of supply cool air to the minimum necessary. Further, since the temperature of a heating element of each server varies from hour to hour, and the rotational speed of an autonomous control fan built in each server (which is hereinafter referred to simply as a built-in fan) varies according to this variation, the necessary volume of supply cool air varies frequently. Due to such circumstances, the volume of supply cool air is set so that it is sufficiently higher than the necessary amount in general data centers, and there is thus room for improvement in terms of electricity cost.

Patent Literature 1 discloses a method of controlling the rotational speed of an outside air introduction fan on the basis of the pressure detected by each of pressure sensors placed in a cold aisle and a hot aisle of a rack. To be specific, when the atmospheric pressure of the cold aisle is higher than the atmospheric pressure of the hot aisle, the rotational speed of the outside air introduction fan is reduced, and when the atmospheric pressure of the cold aisle is lower than the atmospheric pressure of the hot aisle, the rotational speed of the outside air introduction fan is increased.

Generally, in the case where the rotational speed of the outside air introduction fan is low, the boost pressure to the rack becomes lower, and therefore the volume of intake air of each server decreases, and the temperature of the heating element of each server increases. To prevent an increase in the temperature of the heating element of each server, each server increases the rotational speed of the built-in fan. With this increase, the atmospheric pressure of the cold aisle becomes still lower. In the case where the rotational speed of the outside air introduction fan is extremely low, each server tries to increase the rotational speed of the built-in fan in a similar manner. However, there is an upper limit to the rotational speed of the built-in fan, and when the rotational speed of the built-in fan reaches the upper limit, each server cannot increase the rotational speed of the built-in fan any more. In this case, each server fails to have the necessary volume of intake air.

On the other hand, in the case where the rotational speed of the outside air introduction fan is high, the boost pressure to the rack becomes higher, and therefore the volume of intake air of each server increases, and the temperature of the heating element of each server decreases. To reduce the power consumption, each server decreases the rotational speed of the built-in fan. With this decrease, the atmospheric pressure of the cold aisle becomes still higher. In the case where the rotational speed of the outside air introduction fan is extremely high, each server tries to decrease the rotational speed of the built-in fan in a similar manner. However, there is a lower limit to the rotational speed of the built-in fan, and when the rotational speed of the built-in fan reaches the lower limit, each server cannot decrease the rotational speed of the built-in fan any more. In this case, the power is wasted in the outside air introduction fan.

Patent Literature 1 gives consideration to the fact that the rotational speed of the built-in fan is autonomously controlled according to a change in the boost pressure to the rack caused by a change in the rotational speed of the outside air introduction fan. Then, Patent Literature 1 controls the rotational speed of the outside air introduction fan so that a difference between the atmospheric pressure of the cold aisle and the atmospheric pressure of the hot aisle approaches zero. This allows the volume of supply cool air to be properly controlled.

Further, Patent Literature 2 also controls the rotational speed of the outside air introduction fan so that a difference between the atmospheric pressure of the cold aisle and the atmospheric pressure of the hot aisle approaches zero. This allows the volume of supply cool air to be properly controlled.

### Citation List

### Patent Literature

Patent Literature 1: Japanese Unexamined Patent Application Publication No. 2016-91524
Patent Literature 2: Japanese Unexamined Patent Application Publication No. 2016-24562

### Summary of Invention

### Technical Problem

As described above, both of Patent Literatures 1 and 2 control the rotational speed of a fan of an air conditioner (which is hereinafter referred to simply as an air conditioning fan) so that a difference between the atmospheric pressure of the cold aisle and the atmospheric pressure of the hot aisle approaches zero. This burdens the built-in fan of each server with boost pressure at a level balanced out by a pressure loss in each server.

The diameter of the air conditioning fan is significantly greater than the diameter of the built-in fan of each server. Thus, the inventors of the present invention consider that the power consumption of the overall data center is reduced by using the air conditioning fan rather than using the built-in fan when generating the same boost pressure to the rack.

In view of the foregoing, an object of the present invention is to provide an air conditioning control device, method, non-transitory computer readable medium, and air conditioning system that solve any of the above-described problems.

### Solution to Problem

According to one example embodiment of the present invention, an air conditioning control device includes a differential pressure calculation unit configured to calculate differential pressure between an intake side and an exhaust side of a rack containing at least one server, and a rotational speed control unit configured to control a rotational speed of an air conditioning fan on the basis of the differential pressure. The rotational speed control means increases or decreases the rotational speed of the air conditioning fan depending on a variation of the differential pressure in event of a change in the rotational speed of the air conditioning fan.

According to another example embodiment of the present invention, an air conditioning control method includes a differential pressure calculation step of calculating differential pressure between an intake side and an exhaust side of a rack containing at least one server, and a rotational speed control step of controlling a rotational speed of an air conditioning fan on the basis of the differential pressure. The rotational speed control step increases or decreases the rotational speed of the air conditioning fan depending on a variation of the differential pressure in event of a change in the rotational speed of the air conditioning fan.

### Advantageous Effects of Invention

According to the present invention, the rotational speed of an air conditioning fan is increased or decreased depending on the variation of the differential pressure in the event of a change in the rotational speed of the air conditioning fan, and therefore the total power consumption of the air conditioning fan and the built-in fan of each server is reduced.

### Brief Description of Drawings

Fig. 1 is a functional block diagram of an air conditioning control device.
Fig. 2 is a plan view of a server room of a data center.
Fig. 3 is an elevation cross-sectional view of a server room.
Fig. 4 is a functional block diagram of an air conditioning control device and an air conditioner.
Fig. 5 is a view showing a control data management table.
Fig. 6 is a graph showing the relationship between the rotational speed of an air conditioning fan and differential pressure.
Fig. 7 is a control flow of an air conditioning control device.

### Description of Embodiments

### (First Example Embodiment)

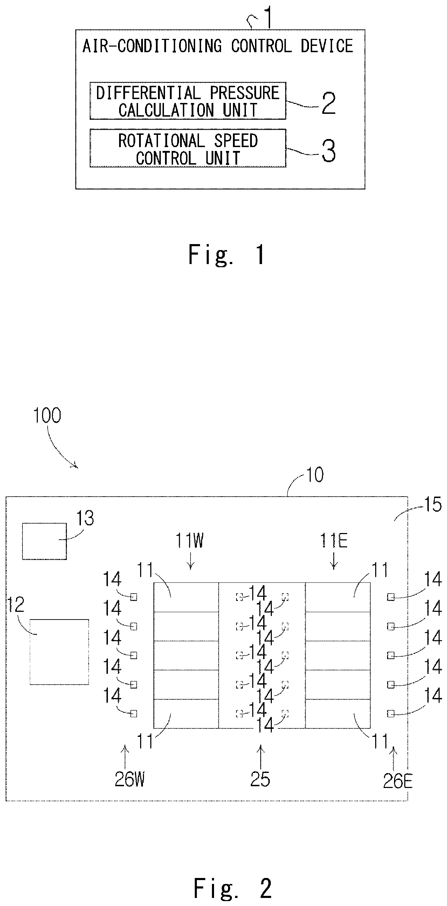

A first example embodiment will be described hereinafter with reference to Fig. 1.

Fig. 1 shows a functional block diagram of an air conditioning control device 1 that controls an air conditioner installed in a server room of a data center. As shown in Fig. 1, the air conditioning control device 1 includes a differential pressure calculation unit 2 and a rotational speed control unit 3.

The differential pressure calculation unit 2 calculates the differential pressure between the intake side and the exhaust side of a rack that contains at least one server.

The rotational speed control unit 3 controls the rotational speed of a fan of an air conditioner (which is hereinafter referred to simply as an air conditioning fan) on the basis of the differential pressure calculated by the differential pressure calculation unit 2.

To be specific, the rotational speed control unit 3 increases or decreases the rotational speed of the air conditioning fan depending on the variation of the differential pressure in the event of a change in the rotational speed of the air conditioning fan.

In this structure, the rotational speed of an air conditioning fan is increased or reduced depending on the variation of the differential pressure in the event of a change in the rotational speed of the air conditioning fan, which reduces the total power consumption of the air conditioning fan and the built-in fan of each server.

### (Second Example Embodiment)

A second example embodiment will be described hereinafter with reference to Figs. 2 to 7.

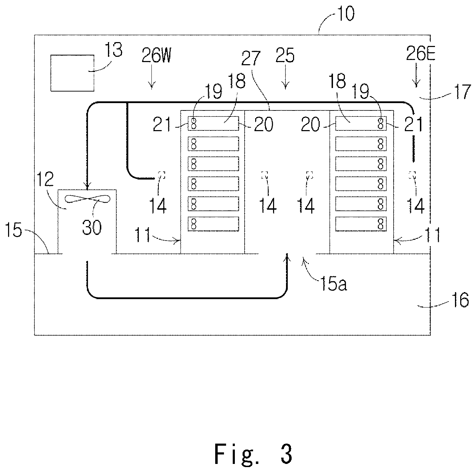

Fig. 2 is a plan view of a server room 10 of a data center. Fig. 3 is an elevation cross-sectional view of the server room 10.

As shown in Figs. 2 and 3, a plurality of racks 11, an air conditioner 12, an air conditioning control device 13, and a plurality of atmospheric pressure sensors 14 are placed in the server room 10.

As shown in Fig. 3, the server room 10 employs a double bottom construction. Specifically, the inner space of the server room 10 is divided into upper and lower spaces by an equipment installation floor 15, so that an underfloor space 16 below the equipment installation floor 15 and a ground space 17 above the equipment installation floor 15 are formed.

In this example embodiment, the plurality of racks 11, the air conditioner 12, the air conditioning control device 13, and the plurality of atmospheric pressure sensors 14 are placed in the ground space 17. However, the air conditioner 12 and the air conditioning control device 13 may be placed in the underfloor space 16 or may be placed across the underfloor space 16 and the ground space 17.

As shown in Fig. 3, the plurality of racks 11 are placed on the equipment installation floor 15. As shown in Fig. 2, the plurality of racks 11 are arranged in two rows. Specifically, the plurality of racks 11 form a right rack row 11E located on the right side of paper and a left rack row 11W located on the left side of paper in Fig. 2. The direction along which the plurality of racks 11 belonging to the right rack row 11E are arranged and the direction along which the plurality of racks 11 belonging to the left rack row 11W are arranged are parallel to each other. The right rack row 11E and the left rack row 11W are opposite to each other in the direction orthogonal to the direction along which the plurality of racks 11 belonging to the right rack row 11E are arranged. In this example embodiment, the left rack row 11W is composed of five racks 11, and the right rack row 11E is composed of five racks 11. However, the number of racks 11 that constitute the left rack row 11W is not limited to five. The same applies to the right rack row 11E.

As shown in Fig. 3, a plurality of servers 18 are contained in each rack 11. In each rack 11, the plurality of servers 18 are arranged vertically with a predetermined space therebetween. In this example embodiment, six servers 18 are contained in each rack 11. However, the number of servers 18 contained in each rack 11 is not limited to six. Each server 18 includes a built-in fan 19 and a CPU or the like, which is not shown. The CPU or the like is one specific example of a heating element. In each server 18, the rotational speed of the built-in fan 19 is autonomously controlled according to the temperature of the CPU or the like. Each server 18 has an intake plane 20 and an exhaust plane 21. The intake plane 20 is a plane where intake of air into each server 18 is done. The exhaust plane 21 is a plane where exhaust of air from each server 18 is done. The plurality of servers 18 are arranged in such a way that the intake plane 20 of each server 18 of each rack 11 belonging to the left rack row 11W and the intake plane 20 of each server 18 of each rack 11 belonging to the right rack row 11E face each other.

Referring back to Fig. 2, the space between the left rack row 11W and the right rack row 11E is a cold aisle 25. The space on the other side of the cold aisle 25 with the left rack row 11W interposed therebetween is a hot aisle 26W. Further, the space on the other side of the cold aisle 25 with the right rack row 11E interposed therebetween is a hot aisle 26E. As shown in Fig. 3, the cold aisle 25 and the underfloor space 16 are continuous through a blowoff opening 15a in the equipment installation floor 15. Further, the cold aisle 25 is covered by an aisle cap 27. The aisle cap 27 divides the cold aisle 25 and the hot aisle 26W and also divides the cold aisle 25 and the hot aisle 26E so as to reduce the short-circuit phenomenon.

The plurality of atmospheric pressure sensors 14 are sensors that measure the atmospheric pressure. To be specific, the plurality of atmospheric pressure sensors 14 measure the static pressure. The plurality of atmospheric pressure sensors 14 are placed in the cold aisle 25, the hot aisle 26W and the hot aisle 26E. To be more specific, as shown in Figs. 2 and 3, one atmospheric pressure sensor 14 is placed on the intake side of each rack 11, and one atmospheric pressure sensor 14 is placed on the exhaust side of each rack 11. In this example embodiment, the atmospheric pressure sensors 14 are placed on the intake side and the exhaust side of one rack 11; however, the atmospheric pressure sensors 14 may be placed opposite to the intake plane 20 and the exhaust plane 21 of each server 18. The plurality of atmospheric pressure sensors 14 are configured to be able to perform data communication with the air conditioning control device 13 by wired or wireless connection. Ethernet (registered trademark), Wi-Fi (registered trademark), ZigBbee (registered trademark) or the like may be used for implementing data communication, though not limited thereto.

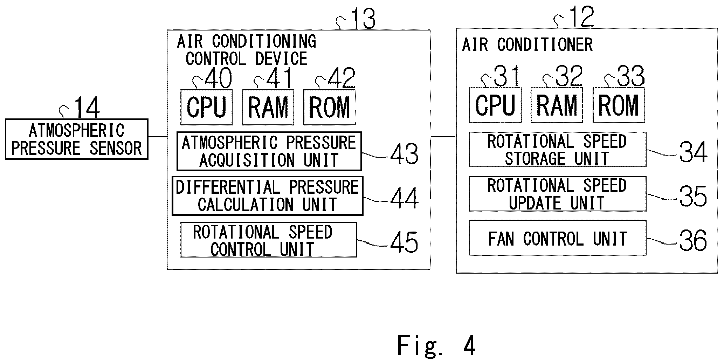

As shown in Fig. 3, the air conditioner 12 is placed on the equipment installation floor 15. The air conditioner 12 includes an air conditioning fan 30. As shown in Fig. 4, the air conditioner 12 includes a CPU 31 (Central Processing Unit) as a central processor. The air conditioner 12 also includes a rewritable RAM 32 (Random Access Memory) and a read-only ROM 33 (Read Only Memory). The CPU 31 reads and executes a program stored in the ROM 33, and the program causes hardware such as the CPU 31 to function as a rotational speed storage unit 34, a rotational speed update unit 35, and a fan control unit 36.

The rotational speed storage unit 34 stores a set value of the rotational speed of the air conditioning fan 30.

The rotational speed update unit 35 updates the set value in the rotational speed storage unit 34.

The fan control unit 36 controls the rotational speed of the air conditioning fan 30 according to the set value stored in the rotational speed storage unit 34.

In this example embodiment, the air conditioner 12 employs an indirect outside air cooling system. The air cooled by the air conditioner 12 is sent to the underfloor space 16 by the air conditioning fan 30.

Referring back to Figs. 2 and 3, the air conditioning control device 13 is placed in the ground space 17. The air conditioning control device 13 is configured to be able to perform data communication with the air conditioner 12 by wired or wireless connection. Ethernet (registered trademark), Wi-Fi (registered trademark), ZigBbee (registered trademark) or the like may be used for implementing data communication, though not limited thereto. Although the air conditioning control device 13 is placed in the ground space 17 in this example embodiment, it may be placed in the underfloor space 16 or placed outside the server room 10.

As shown in Fig. 4, the air conditioning control device 13 includes a CPU 40 (Central Processing Unit) as a central processor. The air conditioning control device 13 also includes a rewritable RAM 41 (Random Access Memory) and a read-only ROM 42 (Read Only Memory). The CPU 40 reads and executes an air conditioning control program stored in the ROM 42, and the air conditioning control program causes hardware such as the CPU 40 to function as an atmospheric pressure acquisition unit 43, a differential pressure calculation unit 44, and a rotational speed control unit 45.

The atmospheric pressure acquisition unit 43 acquires the atmospheric pressure on the intake side and the exhaust side of each rack 11 through the plurality of atmospheric pressure sensors 14, and stores them as atmospheric pressure data into the RAM 41.

The differential pressure calculation unit 44 reads the atmospheric pressure data from the RAM 41, calculates the differential pressure between the intake side and the exhaust side of each rack 11, and stores it as differential pressure data into the RAM 41.

The rotational speed control unit 45 reads the differential pressure data from the RAM 41, and controls the rotational speed of the air conditioning fan 30 of the air conditioner 12 on the basis of the differential pressure data. To be specific, the rotational speed control unit 45 transmits a rotational speed command to the rotational speed update unit 35 of the air conditioner 12. The rotational speed update unit 35 of the air conditioner 12 updates a set value stored in the rotational speed storage unit 34 on the basis of the rotational speed command received from the rotational speed control unit 45. The fan control unit 36 controls the rotational speed of the air conditioning fan 30 on the basis of the set value stored in the rotational speed storage unit 34. In this manner, the rotational speed control unit 45 controls the rotational speed of the air conditioning fan 30 of the air conditioner 12.

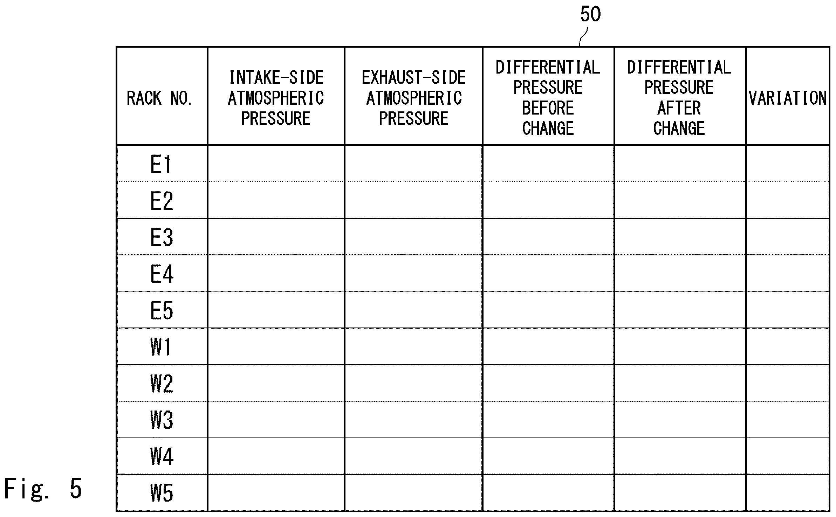

Fig. 5 shows a control data management table 50 stored in the RAM 41. In the control data management table 50, "rack No." is the identification number of each rack 11. E1 to E5 are the identification numbers of the five racks 11 belonging to the right rack row 11E. Likewise, W1 to W5 are the identification numbers of the five racks 11 belonging to the left rack row 11W. "Intake-side atmospheric pressure" is the latest atmospheric pressure on the intake side of the corresponding rack 11. "Exhaust-side atmospheric pressure" is the latest atmospheric pressure on the exhaust side of the corresponding rack 11. "Differential pressure before change" is the differential pressure between the intake side and the exhaust side of the corresponding rack 11 before the rotational speed control unit 45 changes the rotational speed of the air conditioning fan 30. "Differential pressure after change" is the differential pressure between the intake side and the exhaust side of the corresponding rack 11 after the rotational speed control unit 45 changes the rotational speed of the air conditioning fan 30. Note that, in this example embodiment, the differential pressure calculation unit 44 calculates the differential pressure by subtracting "intake-side differential pressure" from "exhaust-side differential pressure". "Variation" is the amount of variation of the differential pressure of the corresponding rack 11 in the event when the rotational speed control unit 45 changes the rotational speed of the air conditioning fan 30. In this example embodiment, "variation" is the absolute value of a difference between "differential pressure before change" and "differential pressure after change". However, "variation" may be an actual difference between "differential pressure before change" and "differential pressure after change".

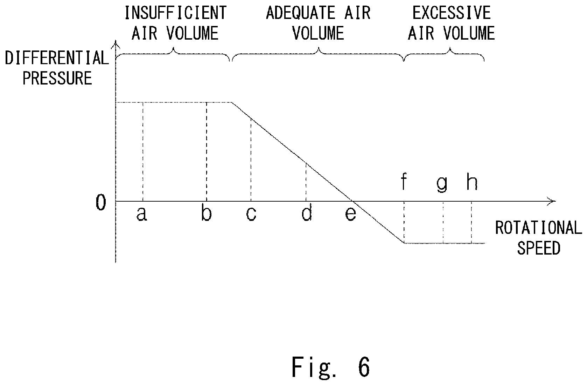

An insufficient air volume state, an adequate air volume state, and an excessive air volume state in the rack 11 are described hereinafter with reference to Fig. 6. The graph of Fig. 6 shows the relationship between the rotational speed of the air conditioning fan 30 and the differential pressure between the intake side and the exhaust side of the rack 11. The horizontal axis of the graph of Fig. 6 indicates the rotational speed of the air conditioning fan 30. The vertical axis of the graph of Fig. 6 indicates the differential pressure between the intake side and the exhaust side of the rack 11.

As shown in Fig. 6, in the case where the rotational speed of the air conditioning fan 30 is too low, the rack 11 is in the insufficient air volume state where the air volume of cool air that cools the rack 11 is insufficient. In this case, the rotational speed of the built-in fans 19 of all the servers 18 contained in the racks 11 is kept at the upper limit. Since the rotational speed of the built-in fans 19 of all the servers 18 is at the upper limit, the differential pressure between the intake side and the exhaust side of the rack 11 has a large positive value. Further, even when the rotational speed of the air conditioning fan 30 is increased from a to b or decreased from b to a in this state, the state where the rotational speed of the built-in fans 19 of all the servers 18 is at the upper limit remains unchanged, and the differential pressure does not change.

In the case where the rotational speed of the air conditioning fan 30 is adequate, the rack 11 is in the adequate air volume state where the air volume of cool air that cools the rack 11 is adequate. In this case, each of the servers 18 contained in the racks 11 autonomously adjusts the rotational speed of the built-in fan 19 successfully according to the temperature of the CPU or the like. Thus, when the rotational speed of the air conditioning fan 30 is increased from c to d or from d to e, the rotational speed of the built-in fan 19 of each server 18 becomes lower, and therefore the differential pressure decreases. Further, when the rotational speed of the air conditioning fan 30 is decreased from e to d or from d to c, the rotational speed of the built-in fan 19 of each server 18 becomes higher, and therefore the differential pressure increases.

In the case where the rotational speed of the air conditioning fan 30 is too high, the rack 11 is in the excessive air volume state where the air volume of cool air that cools the rack 11 is excessive. In this case, the rotational speed of the built-in fans 19 of all the servers 18 contained in the racks 11 is kept at the lower limit. Since the rotational speed of the built-in fans 19 of all the servers 18 is at the lower limit, the differential pressure between the intake side and the exhaust side of the rack 11 has a small value. Even when the rotational speed of the air conditioning fan 30 is increased from g to h or decreased from h to g, the state where the rotational speed of the built-in fans 19 of all the servers 18 is at the lower limit remains unchanged, and the differential pressure does not change.

According to the graph of Fig. 6, the current state of the rack 11 can be grasped by checking the variation of the differential pressure in the event of a change in the rotational speed of the air conditioning fan 30.

As described earlier, Patent Literatures 1 and 2 control the rotational speed of the air conditioning fan so that the differential pressure between the intake side and the exhaust side of the rack 11 approaches zero. Specifically, in Fig. 6, Patent Literatures 1 and 2 control the rotational speed of the air conditioning fan to approach e. As described above, this burdens the built-in fan of each server with boost pressure at a level balanced out by a pressure loss in each server. However, the diameter of the air conditioning fan is significantly greater than the diameter of the built-in fan of each server. Thus, the power consumption of the overall data center is reduced by using the air conditioning fan rather than using the built-in fan when generating the same boost pressure to the rack. Therefore, in this example embodiment, the rotational speed of the air conditioning fan 30 is increased to higher than e as much as possible within the range where the rack 11 does not becomes the excessive air volume state, so that the rotational speed of the air conditioning fan 30 approaches f. This allows the rotational speed of the built-in fan 19 of each server 18 to be kept at the lower limit, which reduces the total power consumption of the air conditioning fan 30 and the built-in fan 19 of each server 18.

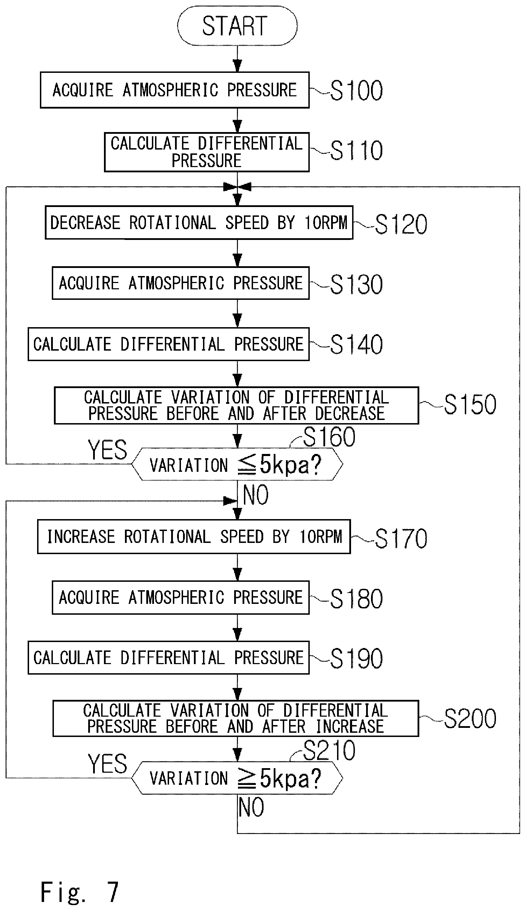

The operation of the air conditioning control device 13 is described hereinafter in detail with reference to Fig. 7. Fig. 7 is a control flow of air conditioning control in the air conditioning control device 13. It is assumed in this example embodiment that the control flow in Fig. 7 is performed by focusing attention only on the rack 11 specified by E1 among the plurality of racks 11. However, the control flow in Fig. 7 may be performed by focusing attention on the plurality of racks 11 and, in this case, it is assumed that, in conditional branching in the control flow, when the condition is met in at least any one of the racks 11, the condition is met in all of the other racks 11. Further, the control flow in Fig. 7 may be performed individually in the plurality of racks 11 and, in this case, it may be performed by focusing attention on the rack 11 with the highest or lowest rotational speed of the air conditioning fan after repeated a predetermined number of steps.

When performing the following control flow, the initial value of the rotational speed of the air conditioning fan 30 is previously set to the maximum value settable as the rotational speed of the air conditioning fan 30. Note that, although this control flow is the control flow that continues the rotational speed control of the air conditioning fan 30, the flow may be restarted from the above-described initial value on a regular basis.

S100:
First, the atmospheric pressure acquisition unit 43 acquires the atmospheric pressure on the intake side of the rack 11 from the atmospheric pressure sensor 14 placed on the intake side of the rack 11. Likewise, the atmospheric pressure acquisition unit 43 acquires the atmospheric pressure on the exhaust side of the rack 11 from the atmospheric pressure sensor 14 placed on the exhaust side of the rack 11. The atmospheric pressure acquisition unit 43 stores the acquired atmospheric pressure as atmospheric pressure data into the "intake-side atmospheric pressure" field and the "exhaust-side atmospheric pressure" field in the control data management table 50 of Fig. 5.

S110:
Next, the differential pressure calculation unit 44 acquires the atmospheric pressure on the intake side and the exhaust side of the rack 11 from the control data management table 50 in Fig. 5, and calculates the differential pressure by subtracting the atmospheric pressure on the intake side from the atmospheric pressure on the exhaust side. The differential pressure calculation unit 44 stores the calculated differential pressure as differential pressure data into the "differential pressure before change" field in the control data management table 50 of Fig. 5.

S120:
Then, the rotational speed control unit 45 transmits the rotational speed command to the rotational speed update unit 35 of the air conditioner 12 so as to decrease the rotational speed of the air conditioning fan 30. In this example, the rotational speed control unit 45 decreases the rotational speed of the air conditioning fan 30 by 10 RPM. Note that, however, the rotational speed of the air conditioning fan 30 is not necessarily decreased by 10 RPM, and it may be decreased by 15 RPM or 20 RPM.

S130:
When a predetermined period of time, such as 10 seconds, for example, has elapsed, the atmospheric pressure acquisition unit 43 acquires the atmospheric pressure on the intake side and the exhaust side of the rack 11 and stores the acquired atmospheric pressure as atmospheric pressure data into the "intake-side atmospheric pressure" field and the "exhaust-side atmospheric pressure" field in the control data management table 50 of Fig. 5.

S140:
Then, the differential pressure calculation unit 44 acquires the atmospheric pressure on the intake side and the exhaust side of the rack 11 from the control data management table 50 in Fig. 5, and calculates the differential pressure by subtracting the atmospheric pressure on the intake side from the atmospheric pressure on the exhaust side. The differential pressure calculation unit 44 stores the calculated differential pressure as differential pressure data into the "differential pressure after change" field in the control data management table 50 of Fig. 5.

S150:
After that, the rotational speed control unit 45 acquires the differential pressure before change and the differential pressure after change from the control data management table 50 of Fig. 5, and calculates the absolute value of the variation of the differential pressure before and after change. Specifically, the rotational speed control unit 45 calculates the absolute value of the variation of the differential pressure before and after decrease.

S160:
Then, the rotational speed control unit 45 determines whether the calculated absolute value of the variation is 5 kpa or less. When the determination results in NO, the rotational speed control unit 45 overwrites "differential pressure before change" with "differential pressure after change" in the control data management table 50 of Fig. 5, and then the process proceeds to S170. On the other hand, when the determination results in YES, i.e., when the calculated absolute value of the variation is 5 kpa or less, the rotational speed control unit 45 overwrites "differential pressure before change" with "differential pressure after change" in the control data management table 50 of Fig. 5, and then the process returns to S120. Specifically, when the determination results in YES, the rotational speed control unit 45 determines that the rack 11 is in the excessive air volume state, and the process returns to S120 so that the rotational speed of the air conditioning fan 30 approaches f. As a result that the process returns to S120, the rotational speed of the air conditioning fan 30 further decreases to lower than the rotational speed after change. Although the rotational speed control unit 45 determines whether the calculated absolute value of the variation is 5 kpa or less in the above example, a comparison may be made with another threshold such as 10 kpa, for example.

According to the above process of S120 to S160, when the rotational speed of the air conditioning fan 30 is g or h in the graph of Fig. 6, the rotational speed of the air conditioning fan 30 decreases toward f.

S170:
Then, the rotational speed control unit 45 transmits the rotational speed command to the rotational speed update unit 35 of the air conditioner 12 so as to increase the rotational speed of the air conditioning fan 30. Here, the rotational speed control unit 45 increases the rotational speed of the air conditioning fan 30 by 10 RPM. Note that, however, the rotational speed of the air conditioning fan 30 is not necessarily increased by 10 RPM, and it may be increased by 15 RPM or 20 RPM.

S180:
When a predetermined period of time, such as 10 seconds, for example, has elapsed, the atmospheric pressure acquisition unit 43 acquires the atmospheric pressure on the intake side and the exhaust side of the rack 11 and stores the acquired atmospheric pressure as atmospheric pressure data into the "intake-side atmospheric pressure" field and the "exhaust-side atmospheric pressure" field in the control data management table 50 of Fig. 5.

S190:
Then, the differential pressure calculation unit 44 acquires the atmospheric pressure on the intake side and the exhaust side of the rack 11 from the control data management table 50 in Fig. 5, and calculates the differential pressure by subtracting the atmospheric pressure on the intake side from the atmospheric pressure on the exhaust side. The differential pressure calculation unit 44 stores the calculated differential pressure as differential pressure data into the "differential pressure after change" field in the control data management table 50 of Fig. 5.

S200:
After that, the rotational speed control unit 45 acquires the differential pressure before change and the differential pressure after change from the control data management table 50 of Fig. 5, and calculates the absolute value of the variation of the differential pressure before and after change. Specifically, the rotational speed control unit 45 calculates the absolute value of the variation of the differential pressure before and after increase.

S210:
Then, the rotational speed control unit 45 determines whether the calculated absolute value of the variation is 5 kpa or more. When the determination results in NO, the rotational speed control unit 45 overwrites "differential pressure before change" with "differential pressure after change" in the control data management table 50 of Fig. 5, and then the process returns to S120. On the other hand, when the determination results in YES, i.e., when the calculated absolute value of the variation is 5 kpa or more, the rotational speed control unit 45 overwrites "differential pressure before change" with "differential pressure after change" in the control data management table 50 of Fig. 5, and then the process returns to S170. Specifically, when the determination results in YES, the rotational speed control unit 45 determines that the rack 11 is in the adequate air volume state, and the process returns to S170 so that the rotational speed of the air conditioning fan 30 approaches f. As a result that the process returns to S170, the rotational speed of the air conditioning fan 30 increases to higher than the rotational speed after change. Although the rotational speed control unit 45 determines whether the calculated absolute value of the variation is 5 kpa or more in the above example, a comparison may be made with another threshold such as 10 kpa, for example. Note that, however, the threshold in the comparative determination in S160 is preferably the same as the threshold in the comparative determination in S210 or equal to or more than the threshold in the comparative determination in S210.

According to the above process of S170 to S210, when the rotational speed of the air conditioning fan 30 is c, d, or e in the graph of Fig. 6, the rotational speed of the air conditioning fan 30 increases toward f.

As described above, the rotational speed control unit 45 monitors the variation of the differential pressure between the intake side and the exhaust side of the rack 11 and controls the rotational speed of the air conditioning fan 30 on the basis of this variation, and thereby the following effects are obtained. Specifically, a sufficient volume of air required to cool the CPU or the like of each server 18 contained in the rack 11 is provided, and the rotational speed of the built-in fan 19 of each server 18 is kept at the lower limit. This allows burdening the air conditioning fan 30 with boost pressure generated by the built-in fan 19 of each server 18 in Patent Literatures 1 and 2 in the range of not causing the rack 11 to be in the excessive air volume state. The total power consumption of the air conditioning fan 30 and the built-in fan 19 of each server 18 is thereby reduced.

The second example embodiment is described above. The above-described second example embodiment has the following features.

The air conditioning control device 13 includes the differential pressure calculation unit 44 that calculates the differential pressure between the intake side and the exhaust side of the rack 11 that contains at least one server 18, and the rotational speed control unit 45 that controls the rotational speed of the air conditioning fan 30 on the basis of the differential pressure. The rotational speed control unit 45 increases or decreases the rotational speed of the air conditioning fan 30 depending on the variation of the differential pressure in the event of a change in the rotational speed of the air conditioning fan 30. In this structure, since the rotational speed of the air conditioning fan 30 is increased or decreased depending on the variation of the differential pressure when the rotational speed of the air conditioning fan 30 changes, the total power consumption of the air conditioning fan 30 and the built-in fan 19 of each server 18 is reduced.

Further, the rotational speed control unit 45 increases or decreases the rotational speed of the air conditioning fan depending on a comparison result of the variation of the differential pressure in the event of a change in the rotational speed of the air conditioning fan with a predetermined value. In this structure, since the rotational speed of the air conditioning fan 30 is increased or decreased depending on a comparison result of the variation of the differential pressure in the event of a change in the rotational speed of the air conditioning fan 30 with a predetermined value, easy control of the rotational speed of the air conditioning fan 30 is achieved.

Further, when the variation of the differential pressure in the event of a change in the rotational speed of the air conditioning fan 30 is equal to or less than 5 kpa (first predetermined value) (S160: YES), the rotational speed control unit 45 decreases the rotational speed of the air conditioning fan 30 to lower than the rotational speed after change (S120). When, on the other hand, the variation is equal to or more than 5 kpa (second predetermined value) (S210: YES), the rotational speed control unit 45 increases the rotational speed of the air conditioning fan 30 to higher than the rotational speed after change (S170). In this structure, the rotational speed of the air conditioning fan 30 approaches f shown in Fig. 6. This allows the rotational speed of the built-in fan 19 of each server 18 to be kept at the lower limit while having the necessary air volume of each server 18, which effectively reduces the total power consumption of the air conditioning fan 30 and the built-in fan 19 of each server 18.

Further, the threshold (first predetermined value) in S160 of Fig. 7 is preferably equal to or more than the threshold (second predetermined value) in S210.

Furthermore, when the variation of the differential pressure in the event of a change in the rotational speed of the air conditioning fan 30 is equal to or less than 5 kpa (first predetermined value) (S160: YES), the rotational speed control unit 45 decreases the rotational speed of the air conditioning fan 30 to lower than the rotational speed after change (S120). This structure allows the rotational speed of the air conditioning fan 30 to approach f shown in Fig. 6 when the rack 11 is in the excessive air volume state, which effectively reduces the total power consumption of the air conditioning fan 30 and the built-in fan 19 of each server 18.

Furthermore, when the variation of the differential pressure in the event of a change in the rotational speed of the air conditioning fan 30 is equal to or more than 5 kpa (second predetermined value) (S210: YES), the rotational speed control unit 45 increases the rotational speed of the air conditioning fan 30 to higher than the rotational speed after change (S170). This structure allows the rotational speed of the air conditioning fan 30 to approach f shown in Fig. 6 when the rack 11 is in the adequate air volume state, which effectively reduces the total power consumption of the air conditioning fan 30 and the built-in fan 19 of each server 18.

The differential pressure calculation unit 44 acquires the atmospheric pressure on the intake side of the rack 11 from the atmospheric pressure sensor 14 placed on the intake side of the rack 11, and acquires the atmospheric pressure on the exhaust side of the rack 11 from the atmospheric pressure sensor 14 placed on the exhaust side of the rack 11. The differential pressure calculation unit 44 preferably calculates the differential pressure on the basis of the atmospheric pressure on the intake side and the exhaust side of the rack 11.

Further, as shown in Fig. 2, in this example embodiment, an air conditioning system 100 includes the above-described air conditioning control device 13, the air conditioner 12 that includes the air conditioning fan 30, the atmospheric pressure sensor 14 placed on the intake side of the rack 11, and the atmospheric pressure sensor 14 placed on the exhaust side of the rack 11.

An air conditioning control method shown in Fig. 7 includes a differential pressure calculation step (S110, S140, S190) of calculating the differential pressure between the intake side and the exhaust side of the rack 11 that contains at least one server 18. The air conditioning control method includes a rotational speed control step (S120 to S160, S170 to S210) of controlling the rotational speed of the air conditioning fan 30 on the basis of the differential pressure. The rotational speed control step increases or decreases the rotational speed of the air conditioning fan 30 (S120, S170) depending on the variation of the differential pressure in the event of a change in the rotational speed of the air conditioning fan 30 (S160, S210). In this method, since the rotational speed of the air conditioning fan 30 is increased or decreased depending on the variation of the differential pressure in the event of a change in the rotational speed of the air conditioning fan 30, the total power consumption of the air conditioning fan 30 and the built-in fan 19 of each server 18 is reduced.

In the above-described example, the program can be stored and provided to a computer using any type of non-transitory computer readable medium. The non-transitory computer readable medium includes any type of tangible storage medium. Examples of the non-transitory computer readable medium include magnetic storage media (such as floppy disks, magnetic tapes, hard disk drives, etc.), optical magnetic storage media (e.g. magneto-optical disks), CD-ROM (Read Only Memory), CD-R , CD-R/W, and semiconductor memories (such as mask ROM, PROM (Programmable ROM), EPROM (Erasable PROM), flash ROM, RAM (Random Access Memory), etc.). The program may be provided to a computer using any type of transitory computer readable medium. Examples of the transitory computer readable medium include electric signals, optical signals, and electromagnetic waves. The transitory computer readable medium can provide the program to a computer via a wired communication line such as an electric wire or optical fiber or a wireless communication line.

The whole or part of the example embodiments disclosed above can be described as, but not limited to, the following supplementary notes.

### (Supplementary Note 1)

An air conditioning control device includes a differential pressure calculation means for calculating differential pressure between an intake side and an exhaust side of a rack containing at least one server and a rotational speed control means for controlling a rotational speed of an air conditioning fan on the basis of the differential pressure, wherein the rotational speed control means increases or decreases the rotational speed of the air conditioning fan depending on a variation of the differential pressure in event of a change in the rotational speed of the air conditioning fan.

### (Supplementary Note 2)

In the air conditioning control device according to Supplementary Note 1, wherein the rotational speed control means increases or decreases the rotational speed of the air conditioning fan depending on a comparison result of the variation of the differential pressure in event of a change in the rotational speed of the air conditioning fan with a predetermined value.

### (Supplementary Note 3)

In the air conditioning control device according to Supplementary Note 1 or 2, wherein when the variation of the differential pressure in event of a change in the rotational speed of the air conditioning fan is equal to or less than a first predetermined value, the rotational speed control means decreases the rotational speed of the air conditioning fan to lower than the rotational speed after change, and when the variation is equal to or more than a second predetermined value, the rotational speed control means increases the rotational speed of the air conditioning fan to higher than the rotational speed after change.

### (Supplementary Note 4)

In the air conditioning control device according to Supplementary Note 3, wherein the first predetermined value is equal to or more than the second predetermined value.

### (Supplementary Note 5)

In the air conditioning control device according to Supplementary Note 1 or 2, wherein when the variation of the differential pressure in event of a change in the rotational speed of the air conditioning fan is equal to or less than a first predetermined value, the rotational speed control means decreases the rotational speed of the air conditioning fan to lower than the rotational speed after change.

### (Supplementary Note 6)

In the air conditioning control device according to Supplementary Note 1 or 2, wherein when the variation of the differential pressure in event of a change in the rotational speed of the air conditioning fan is equal to or more than a second predetermined value, the rotational speed control means increases the rotational speed of the air conditioning fan to higher than the rotational speed after change.

### (Supplementary Note 7)

In the air conditioning control device according to any one of Supplementary Notes 1 to 6, wherein the differential pressure calculation means acquires atmospheric pressure on the intake side of the rack from an atmospheric pressure sensor placed on the intake side of the rack, acquires atmospheric pressure on the exhaust side of the rack from an atmospheric pressure sensor placed on the exhaust side of the rack, and calculates the differential pressure on the basis of the atmospheric pressure on the intake side and the exhaust side of the rack.

### (Supplementary Note 8)

An air conditioning system includes the air conditioning control device according to any one of Supplementary Notes 1 to 6; an air conditioner including the air conditioning fan; an atmospheric pressure sensor placed on the intake side of the rack; and an atmospheric pressure sensor placed on the exhaust side of the rack.

### (Supplementary Note 9)

An air conditioning control method includes a differential pressure calculation step of calculating differential pressure between an intake side and an exhaust side of a rack containing at least one server; and a rotational speed control step of controlling a rotational speed of an air conditioning fan on the basis of the differential pressure, wherein the rotational speed control step increases or decreases the rotational speed of the air conditioning fan depending on a variation of the differential pressure in event of a change in the rotational speed of the air conditioning fan.

### (Supplementary Note 10)

A non-transitory computer readable medium storing a program causing a computer to execute the air conditioning control method according to Supplementary Note 9.

### (Supplementary Note 11)

In the air conditioning control device according to Supplementary Note 1 or 2, wherein when the variation of the differential pressure in event of a decrease in the rotational speed of the air conditioning fan is equal to or less than a first predetermined value, the rotational speed control means further decreases the rotational speed of the air conditioning fan to lower than the rotational speed after decrease.

### (Supplementary Note 12)

In the air conditioning control device according to Supplementary Note 1 or 2, wherein when the variation of the differential pressure in event of an increase in the rotational speed of the air conditioning fan is equal to or more than a second predetermined value, the rotational speed control means further increases the rotational speed of the air conditioning fan to higher than the rotational speed after increase.

Although the present invention has been described with reference to the example embodiments, the present invention is not limited by the above. The configuration and details of the present invention may be modified in various ways as will be understood by those skilled in the art within the scope of the disclosure.

This application is based upon and claims the benefit of priority from Japanese patent application No. 2019-049262 filed on March 18, 2019, the disclosure of which is incorporated herein in its entirety by reference.

### Reference Signs List

- 1: AIR-CONDITIONING CONTROL DEVICE
- 2: DIFFERENTIAL PRESSURE CALCULATION UNIT
- 3: ROTATIONAL SPEED CONTROL UNIT
- 10: SERVER ROOM
- 11: RACK
- 11E: RIGHT RACK ROW
- 11W: LEFT RACK ROW
- 12: AIR CONDITIONER
- 13: AIR-CONDITIONING CONTROL DEVICE
- 14: ATMOSPHERIC PRESSURE SENSOR
- 15: EQUIPMENT INSTALLATION FLOOR
- 15A: BLOWOFF OPENING
- 16: UNDERFLOOR SPACE
- 17: GROUND SPACE
- 18: SERVER
- 19: BUILT-IN FAN
- 20: INTAKE PLANE
- 21: EXHAUST PLANE
- 25: COLD AISLE
- 26W: HOT AISLE
- 26E: HOT AISLE
- 27: AISLE CAP
- 30: AIR CONDITIONING FAN
- 34: ROTATIONAL SPEED STORAGE UNIT
- 35: ROTATIONAL SPEED UPDATE UNIT
- 36: FAN CONTROL UNIT
- 43: ATMOSPHERIC PRESSURE ACQUISITION UNIT
- 44: DIFFERENTIAL PRESSURE CALCULATION UNIT
- 45: ROTATIONAL SPEED CONTROL UNIT
- 50: CONTROL DATA MANAGEMENT TABLE
- 100: AIR CONDITIONING SYSTEM

## Claims

1. An air conditioning control device comprising:
a differential pressure calculation means for calculating differential pressure between an intake side and an exhaust side of a rack containing at least one server; and
a rotational speed control means for controlling a rotational speed of an air conditioning fan on the basis of the differential pressure,
wherein the rotational speed control means increases or decreases the rotational speed of the air conditioning fan depending on a variation of the differential pressure in event of a change in the rotational speed of the air conditioning fan.

2. The air conditioning control device according to Claim 1, wherein the rotational speed control means increases or decreases the rotational speed of the air conditioning fan depending on a comparison result of the variation of the differential pressure in event of a change in the rotational speed of the air conditioning fan with a predetermined value.

3. The air conditioning control device according to Claim 1 or 2, wherein when the variation of the differential pressure in event of a change in the rotational speed of the air conditioning fan is equal to or less than a first predetermined value, the rotational speed control means decreases the rotational speed of the air conditioning fan to lower than the rotational speed after change, and when the variation is equal to or more than a second predetermined value, the rotational speed control means increases the rotational speed of the air conditioning fan to higher than the rotational speed after change.

4. The air conditioning control device according to Claim 3, wherein the first predetermined value is equal to or more than the second predetermined value.

5. The air conditioning control device according to Claim 1 or 2, wherein when the variation of the differential pressure in event of a change in the rotational speed of the air conditioning fan is equal to or less than a first predetermined value, the rotational speed control means decreases the rotational speed of the air conditioning fan to lower than the rotational speed after change.

6. The air conditioning control device according to Claim 1 or 2, wherein when the variation of the differential pressure in event of a change in the rotational speed of the air conditioning fan is equal to or more than a second predetermined value, the rotational speed control means increases the rotational speed of the air conditioning fan to higher than the rotational speed after change.

7. The air conditioning control device according to any one of Claims 1 to 6, wherein the differential pressure calculation means acquires atmospheric pressure on the intake side of the rack from an atmospheric pressure sensor placed on the intake side of the rack, acquires atmospheric pressure on the exhaust side of the rack from an atmospheric pressure sensor placed on the exhaust side of the rack, and calculates the differential pressure on the basis of the atmospheric pressure on the intake side and the exhaust side of the rack.

8. An air conditioning system comprising:
the air conditioning control device according to any one of Claims 1 to 6;
an air conditioner including the air conditioning fan;
an atmospheric pressure sensor placed on the intake side of the rack; and
an atmospheric pressure sensor placed on the exhaust side of the rack.

9. An air conditioning control method comprising:
a differential pressure calculation step of calculating differential pressure between an intake side and an exhaust side of a rack containing at least one server; and
a rotational speed control step of controlling a rotational speed of an air conditioning fan on the basis of the differential pressure,
wherein the rotational speed control step increases or decreases the rotational speed of the air conditioning fan depending on a variation of the differential pressure in event of a change in the rotational speed of the air conditioning fan.

10. A non-transitory computer readable medium storing a program causing a computer to execute the air conditioning control method according to Claim 9.

11. The air conditioning control device according to Claim 1 or 2, wherein when the variation of the differential pressure in event of a decrease in the rotational speed of the air conditioning fan is equal to or less than a first predetermined value, the rotational speed control means further decreases the rotational speed of the air conditioning fan to lower than the rotational speed after decrease.

12. The air conditioning control device according to Claim 1 or 2, wherein when the variation of the differential pressure in event of an increase in the rotational speed of the air conditioning fan is equal to or more than a second predetermined value, the rotational speed control means further increases the rotational speed of the air conditioning fan to higher than the rotational speed after increase.
